# EUROPEAN PATENT APPLICATION

(11) **EP 4 753 385 A1**
(43) Date of publication of application: **03.06.2026**
(21) Application number: 25184695.2
(22) Date of filing: 23.06.2025
(51) Int. Cl.: H05K 7/14

(54) **BRACKET DEVICE AND RELATED SLIDE RAIL MECHANISM**

(30) Priority: 28.11.2024 TW 113146399
(71) Applicant: King Slide Works Co., Ltd., Kaohsiung City 821 (TW); King Slide Technology Co., Ltd., 82151 Kaohsiung City (TW)
(72) Inventor: Chen, Ken-Ching, 821 Kaohsiung City (TW); Yang, Shun-Ho, 821 Kaohsiung City (TW); Weng, Tzu-Cheng, 821 Kaohsiung City (TW); Wang, Chun-Chiang, 821 Kaohsiung City (TW)
(74) Representative: Straus, Alexander

(57) **Abstract**

A bracket device(24) arranged on a slide rail(22) and configured to be mounted on a rack is provided and includes a reinforcing member(28), a first bracket(30), a first supporting member(32), a second supporting member(34) and a second bracket(36). The reinforcing member(28) is connected to the slide rail(22). The first bracket(30) is arranged on one of the slide rail(22) and the reinforcing member(28). The first supporting member(32) and the second supporting member(34) are movable relative to the reinforcing member(28). The second bracket(36) is arranged on the second supporting member(34). The first supporting member(32) can be positioned at different predetermined positions relative to the reinforcing member(28), so as to enable a first mounting member(44) on the first bracket(30) and a second mounting member(56) on the second bracket(36) to be spaced apart from each other by different distances. Besides, a related slide rail mechanism(20)is also provided.

## Description

### Field of the Invention

The present invention relates to a bracket device and a slide rail mechanism according to the pre-characterizing clauses of claims 1 and 13.

### Background of the Invention

In U.S. Patent No. 6,230,903 B1, it discloses a slide rail mechanism including an outer rail, a middle rail and an inner rail movable relative to one another. The outer rail is mounted on a first post and a second post of a rack by a first bracket and a second bracket, respectively. Furthermore, the first bracket is fastened on a portion of the outer rail by at least one screw member, and the second bracket is movably mounted on another portion of the outer rail. Besides, a spring is mounted between the second bracket and the outer rail, and a rotary knob is provided and configured to be tightened to prevent a movement of the second bracket relative to the outer rail, or to be loosened to allow the movement of the second bracket relative to outer rail. The first bracket and the second bracket are two separated members which are provided with a plurality of first mounting pins and a plurality of second mounting pins configured to be mounted on the first post and the second post of the rack, respectively.

In U.S. Patent No. 6,666,340 B2, it discloses a universal slide rail including a first bracket, e.g., an inner rail, and a second bracket, e.g., an outer rail. The first bracket is provided with a plurality of holes, and the second bracket is provided with a primary locking mechanism. A biasing mechanism is disposed between the primary locking mechanism and the second bracket. Furthermore, the primary locking mechanism includes a protruding lug configured to engage with a corresponding one of the plurality of holes for locking a relative position of the first bracket and the second bracket. The first bracket and the second bracket are configured to be mounted on a first post and a second post of a rack, respectively.

However, in order to meet different requirements, it becomes an important topic to provide a different slide rail product.

### Summary of the Invention

This is mind, the present invention aims at providing a bracket device and a slide rail mechanism with enhanced reliability and safety in mounting.

This is achieved by a bracket device and a slide rail mechanism according to claims 1 and 13. The dependent claims pertain to corresponding further developments and improvements.

As will be seen more clearly from the detail description following below, the claimed bracket device is arranged on a slide rail and configured to be mounted on a rack. The bracket device includes a reinforcing member, a first bracket, a first supporting member, a second supporting member and a second bracket. The reinforcing member is connected to the slide rail. The first bracket is arranged on one of the slide rail and the reinforcing member, and a first mounting member is arranged on the first bracket. The first supporting member is movably mounted on the reinforcing member. The second supporting member is movably mounted on the first supporting member. The second bracket is arranged on the second supporting member, and a second mounting member is arranged on the second bracket. A plurality of predetermined features are arranged on one of the reinforcing member and the first supporting member, and an engaging feature is arranged on another one of the reinforcing member and the first supporting member. When the engaging feature engages with one of the plurality of predetermined features, the first supporting member is located at a first predetermined position relative to the reinforcing member, and the first mounting member on the first bracket and the second mounting member on the second bracket are spaced apart from each other by a first distance. When the engaging feature engages with another one of the plurality of predetermined features, the first supporting member is located at a second predetermined position different from the first predetermined position relative to the reinforcing member, and the first mounting member on the first bracket and the second mounting member on the second bracket are spaced apart from each other by a second distance different from the first distance.

Furthermore, the claimed slide rail mechanism is adapted for a rack and includes a slide rail and the aforementioned bracket device arranged on the slide rail.

In summary, in the present invention, the reinforcing member and the first supporting member are movable relative to each other. Accordingly, a distance between the first mounting member on the first bracket and the second mounting member on the second bracket can be adjusted by adjusting a relative position of the first supporting member and the reinforcing member, without any change of a relative position of the first supporting member and the second supporting member.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof:
FIG. 1 is a schematic diagram of a slide rail mechanism according to an embodiment of the present invention,
FIG. 2 is an exploded diagram of the slide rail mechanism according to the embodiment of the present invention,
FIG. 3 is a diagram of the slide rail mechanism, in which a first bracket and a second bracket are spaced apart from each other by a first distance, according to the embodiment of the present invention,
FIG. 4 is a diagram of the slide rail mechanism, in which the first bracket and the second bracket are spaced apart from each other by a second distance, according to the embodiment of the present invention,
FIG. 5 is a sectional diagram of the slide rail mechanism according to the embodiment of the present invention,
FIG. 6 is a diagram of the slide rail mechanism adapted for a first rack having a first longitudinal depth according to the embodiment of the present invention,
FIG. 7 is a diagram of the slide rail mechanism adapted for a second rack having a second longitudinal depth according to the embodiment of the present invention,
FIG. 8 is a diagram of the slide rail mechanism, in which an engaging feature engages with one of a plurality of predetermined features to retain a first supporting member at a predetermined position relative to a reinforcing member, according to the embodiment of the present invention,
FIG. 9 is a diagram of the slide rail mechanism, in which the engaging feature disengages from the one of the plurality of predetermined features to allow the first supporting member to move away from the predetermined position relative to the reinforcing member, according to the embodiment of the present invention, and
FIG. 10 is a diagram of the slide rail mechanism, in which the engaging feature engages with another one of the plurality of predetermined features to retain the first supporting member at another predetermined position relative to the reinforcing member, according to the embodiment of the present invention.

### Detailed Description

In the following detailed description of the preferred embodiments, reference is made to the accompanying drawings which form a part hereof, and in which is shown by way of illustration specific embodiments in which the invention may be practiced. In this regard, directional terminology, such as "top", "bottom", "left", "right", "front", "back", etc., is used with reference to the orientation of the Figure(s) being described. The components of the present invention can be positioned in a number of different orientations. As such, the directional terminology is used for purposes of illustration and is in no way limiting. Accordingly, the drawings and descriptions will be regarded as illustrative in nature and not as restrictive. Also, if not specified, the term "connect" is intended to mean either an indirect or direct mechanical connection. Thus, if a first device is connected to a second device, that connection may be through a direct mechanical connection, or through an indirect mechanical connection via other devices and connections.

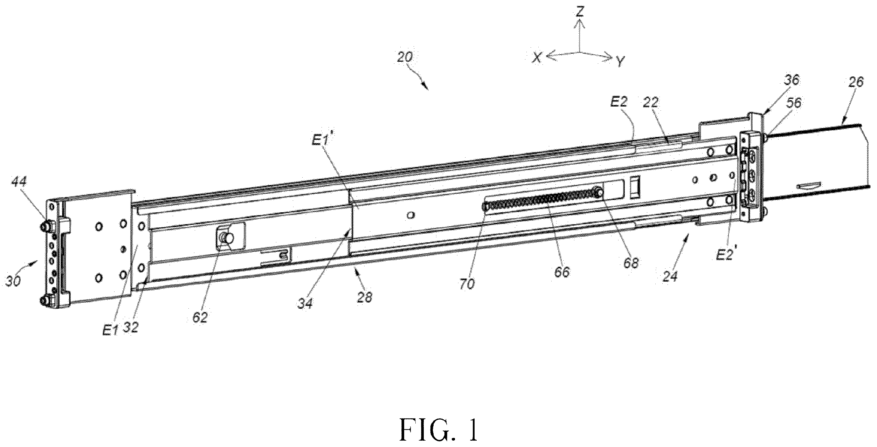

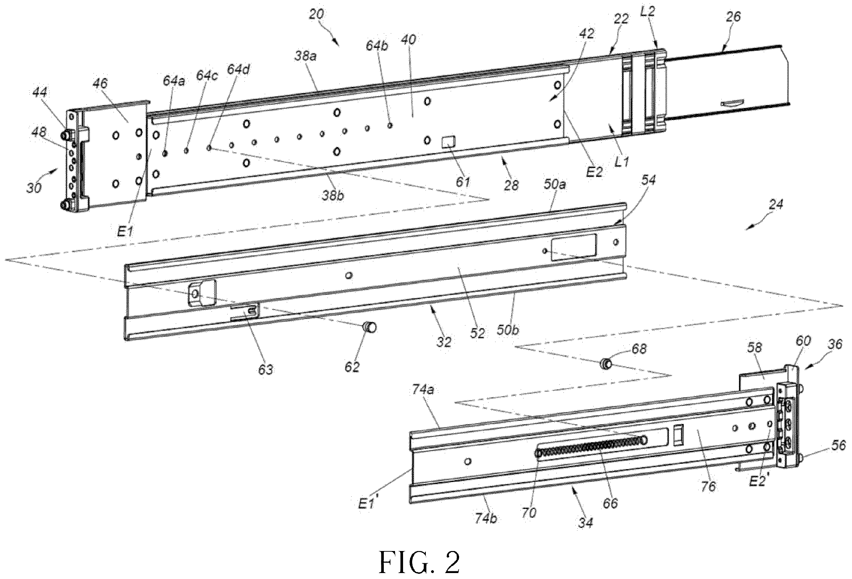

As shown in FIG. 1 and FIG. 2, a slide rail mechanism 20 includes a slide rail 22 and a bracket device 24. The slide rail 22 has a first side L1 and a second side L2 opposite to the first side L1. In this embodiment, by way of example, the first side L1 and the second side L2 of the slide rail 22 can be an outer side and an inner side of the slide rail 22, respectively. However, the present invention is not limited to this embodiment. Preferably, the slide rail mechanism 20 further includes a movable rail 26 movably mounted on the second side L2 of the slide rail 22 and displaceable relative to the slide rail 22 along a longitudinal direction. In this embodiment, by way of example, the longitudinal direction can be defined by a length direction of the slide rail 22, and parallel to an X axis. A transverse direction can be defined by a lateral direction of the slide rail 22, and parallel to a Y axis. A vertical direction can be defined by a height direction of the slide rail 22, and parallel to a Z axis.

The bracket device 24 is arranged on the first side L1 of the slide rail 22. The bracket device 24 includes a reinforcing member 28, a first bracket 30, a first supporting member 32, a second supporting member 34 and a second bracket 36.

The reinforcing member 28 is connected, e.g., fixedly connected, to the first side L1 of the slide rail 22. The reinforcing member 28 has a first end E1 and a second end E2 opposite to the first end E1. Preferably, the reinforcing member 28 includes a first wall 38a, a second wall 38b and a longitudinal wall 40 connected between the first wall 38a and the second wall 38b of the reinforcing member 28, and the first wall 38a, the second wall 38b and the longitudinal wall 40 of the reinforcing member 28 cooperatively define a reinforcing channel 42 of the reinforcing member 28.

The first bracket 30 is arranged on one of the slide rail 22 and the reinforcing member 28. In this embodiment, by way of example, the first bracket 30 is arranged on the slide rail 22 and located adjacent to the first end E1 of the reinforcing member 28. However, the present invention is not limited to this embodiment. For example, in an alternative embodiment, the first bracket 30 is connected, e.g., fixedly connected, to the reinforcing member 28 and located adjacent to the first end E1 of the reinforcing member 28. At least one first mounting member 44 is arranged on the first bracket 30. Preferably, the first bracket 30 includes a lateral wall 46 and an end wall 48 bent substantially perpendicularly relative to the lateral wall 46. The lateral wall 46 of the first bracket 30 is connected, e.g., fixedly connected, to the first side L1 of the slide rail 22. The first mounting member 44 is arranged on the end wall 48 of the first bracket 30.

The first supporting member 32 is movably mounted on the reinforcing channel 42 of the reinforcing member 28. The first supporting member 32 includes a first wall 50a, a second wall 50b and a longitudinal wall 52 connected between the first wall 50a and the second wall 50b of the first supporting member 32, and the first wall 50a, the second wall 50b and the longitudinal wall 52 of the first supporting member 32 cooperatively define a supporting channel 54 of the first supporting member 32.

The second supporting member 34 is movably mounted on the supporting channel 54 of the first supporting member 32. Furthermore, the second supporting member 34 has a first end E1' and a second end E2' opposite to the first end E1'. The first end E1' of the second supporting member 34 is configured to stretch into the supporting channel 54 of the first supporting member 32, and the second bracket 36 is arranged on the second end E2' of the second supporting member 34.

At least one second mounting member 56 is arranged on the second bracket 36. The second bracket 36 is located away from the first end E1 of the reinforcing member 28. In other words, the second bracket 36 is closer to the second end E2 of the reinforcing member 28 than the first bracket 30. Preferably, the second bracket 36 includes a lateral portion 58 and an end portion 60 bent substantially perpendicularly relative to the lateral portion 58. The lateral portion 58 of the second bracket 36 is connected, e.g., fixedly connected, to the second end E2' of the second supporting member 34. The second mounting member 56 is arranged on the end portion 60 of the second bracket 36.

It should be noticed that, a plurality of predetermined features are arranged on one of the reinforcing member 28 and the first supporting member 32, and an engaging feature 62 is arranged on the other one of the reinforcing member 28 and the first supporting member 32. In this embodiment, by way of example, the plurality of predetermined features, e.g., a first predetermined feature 64a, a second predetermined feature 64b, a third predetermined feature 64c and a fourth predetermined feature 64d, are arranged on the longitudinal wall 40 of the reinforcing member 28, and the engaging feature 62 is arranged on the longitudinal wall 52 of the first supporting member 32. Preferably, the third predetermined feature 64c and the fourth predetermined feature 64d are located between the first predetermined feature 64a and the second predetermined feature 64b, and the plurality of predetermined features are evenly spaced at a predetermined interval along the longitudinal direction.

Preferably, in this embodiment, by way of example, each of the plurality of predetermined features is a hole structure defined by at least one hole wall, and the engaging feature 62 is a pin. However, the present invention is not limited to this embodiment.

Preferably, the bracket device 24 further includes a resilient member 66 mounted between the first supporting member 32 and the second supporting member 34. In this embodiment, by way of example, a first mounting feature 68 and a second mounting feature 70 are arranged on the first supporting member 32 and the second supporting member 34, respectively, and two ends of the resilient member 66 are connected to the first mounting feature 68 and the second mounting feature 70, respectively.

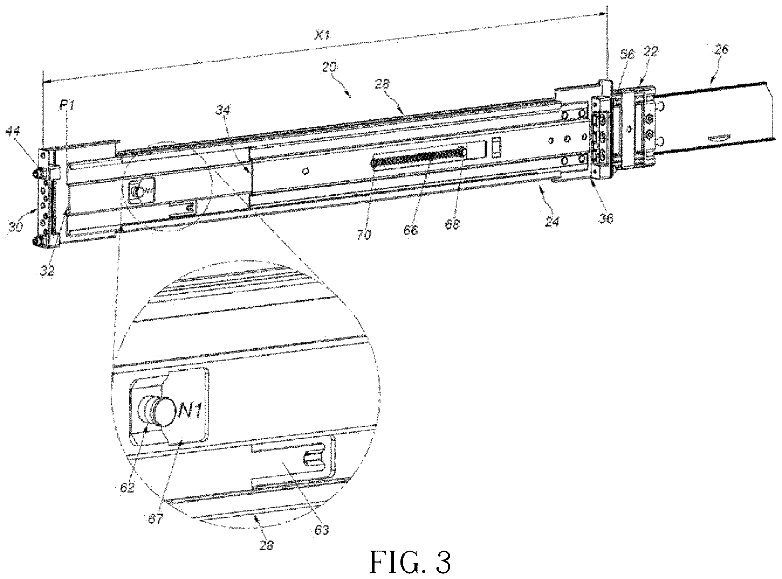

As shown in FIG. 2 and FIG. 3, when the engaging feature 62 engages with the first predetermined feature 64a, the first supporting member 32 can be retained at a first predetermined position P1 relative to the reinforcing member 28, and the first mounting member 44 on the first bracket 30 and the second mounting member 56 on the second bracket 36 are spaced apart from each other by a first distance X1.

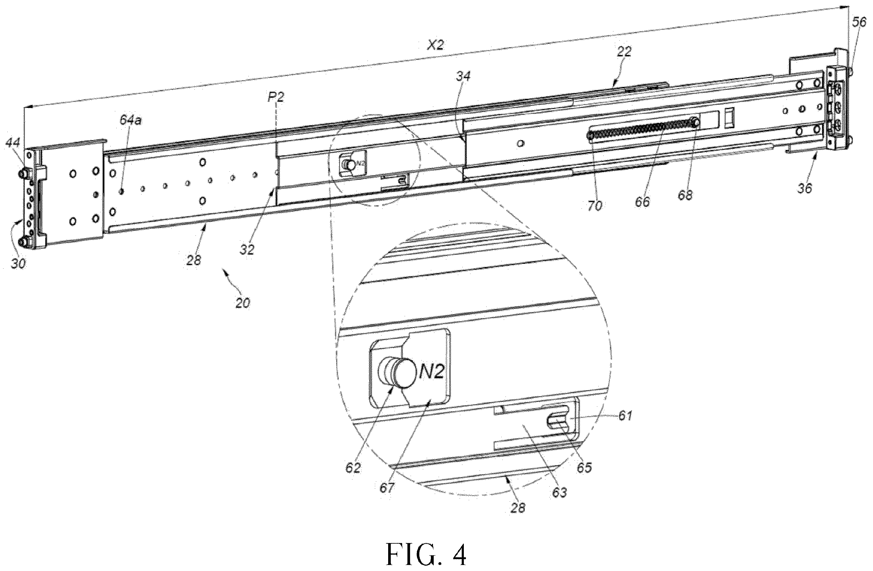

As shown in FIG. 2 and FIG. 4, when the first supporting member 32 is moved from the first predetermined position P1 to a second predetermined position P2 different from the first predetermined position P1 relative to the reinforcing member 28 along the longitudinal direction and the engaging feature 62 engages with the second predetermined feature 64b, the first supporting member 32 can be retained at the second predetermined position P2 relative to the reinforcing member 28, and the first mounting member 44 on the first bracket 30 and the second mounting member 56 on the second bracket 36 are spaced apart from each other by a second distance X2 different from the first distance X1. In this embodiment, by way of example, the second distance X2 is greater than the first distance X1. In other words, when the first supporting member 32 is located at the second predetermined position P2 rather than the first predetermined position P1, the bracket device 24 can have an increased length, so as to be more suitable for use with a rack having a greater depth.

Preferably, a first restraining feature 61 is further arranged on the reinforcing member 28, and a second restraining feature 63 is further arranged on the first supporting member 32. When the first supporting member 32 is moved to the second predetermined position P2 relative to the reinforcing member 28 along the longitudinal direction, the first restraining feature 61 and the second restraining feature 63 engage with each other to restrain the first supporting member 32 from moving away from the second predetermined position P2. In this embodiment, by way of example, the first restraining feature 61 is a hole structure, and the second restraining feature 63 is a resilient arm with a protruding section 65 configured to engage with a hole wall of the first restraining feature 61.

From the above, the first supporting member 32 can be retained at different positions relative to the reinforcing member 28 through an engagement of the engaging feature 62 and a corresponding one of the plurality of predetermined features, thereby enabling the bracket device 24 to have an adjustable length within a predetermined length range, without any change of a relative position of the first supporting member 32 and the second supporting member 34, so as to prevent the adjustable length of the bracket device 24 from being affected by a resilient force and/or a maximum extension length provided by the resilient member 66, which is mounted between the first supporting member 32 and the second supporting member 34.

Preferably, as shown in FIG. 3 and FIG. 4, the reinforcing member 28 includes a plurality of identification features, e.g., a first identification feature N1 and a second identification feature N2, located on the longitudinal wall 40 of the reinforcing wall 28, and the first supporting member 32 includes a window 67 located on the longitudinal wall 52 of the first supporting member 32. The window 67 is configured to reveal one of the plurality of identification features for allowing a user to recognize the adjustable length of the bracket device 24 and/or the distance between the first mounting member 44 and the second mounting member 56, so as to offer convenience in mounting the bracket device 24 on the racks having different longitudinal depths. By way of example, each of the identification features can be a numeral, a text, a pattern or a symbol. However, the present invention is not limited to these examples.

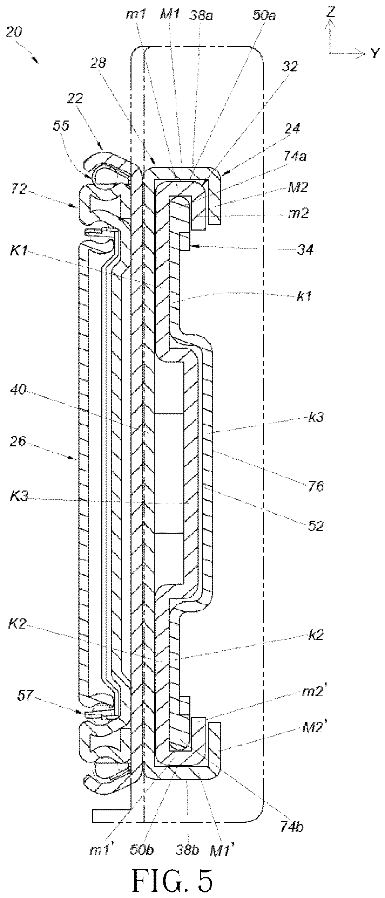

As shown in FIG. 5, the slide rail mechanism 20 further includes a middle rail 72 movably mounted between the slide rail 22 and the movable rail 26, and the slide rail 22 and the movable rail 26 can be considered as an outer rail and an inner rail relative to the middle rail 72, respectively. Preferably, a first rolling ball device 55 is arranged between the slide rail 22 and the middle rail 72 to facilitate a smooth relative displacement of the slide rail 22 and the middle rail 72 along the longitudinal direction, and a second rolling ball device 57 is arranged between the middle rail 72 and the movable rail 26 to facilitate a smooth relative displacement of the middle rail 72 and the movable rail 26 along the longitudinal direction. Besides, the first wall 38a and the second wall 38b of the reinforcing member 28 are configured to embrace the first wall 50a and the second wall 50b of the first supporting member 32, respectively, and the first wall 50a and the second wall 50b of the first supporting member 32 are configured to embrace a first wall 74a and a second wall 74b of the second supporting member 34, respectively.

Preferably, the first wall 38a of the reinforcing member 28 includes a first section M1 and a second section M2 bent relative to the first section M1, and the second wall 38b of the reinforcing member 28 includes a first section M1' and a second section M2' bent relative to the first section M1'. In this embodiment, by way of example, the second section M2 is bent perpendicularly relative to the first section M1, and the second section M2' is bent perpendicularly relative to the first section M1'. However, the present invention is not limited to this embodiment. Furthermore, the first wall 50a of the first supporting member 32 includes a first section m1 and a second section m2 bent relative to the first section m1, and the second wall 50b of the first supporting member 32 includes a first section m1' and a second section m2' bent relative to the first section m1'. In this embodiment, by way of example, the second section m2 is bent perpendicularly relative to the first section m1, and the second section m2' is bent perpendicularly relative to the first section m1'. However, the present invention is not limited to this embodiment. The aforementioned configuration enables the reinforcing member 28 and the first supporting member 32 to embrace the first supporting member 32 and the second supporting member 34, respectively, thereby improving an overall structural strength and a supporting strength of the bracket device 24.

Preferably, the second supporting member 34 includes a longitudinal wall 76 connected between the first wall 74a and the second wall 74b of the second supporting member 34. The longitudinal wall 52 of the first supporting member 32 and the longitudinal wall 76 of the second supporting member 34 are configured to support each other. The longitudinal wall 52 of the first supporting member 32 includes a first wall portion K1, a second wall portion K2 and a third wall portion K3 bent relative to the first wall portion K1 and the second wall portion K2. In this embodiment, by way of example, the third wall portion K3 is bent perpendicularly relative to the first wall portion K1 and the second wall portion K2. However, the present invention is not limited to this embodiment. Furthermore, the longitudinal wall 76 of the second supporting member 34 includes a first wall portion k1, a second wall portion k2 and a third wall portion k3 bent relative to the first wall portion k1 and the second wall portion k2. In this embodiment, by way of example, the third wall portion k3 is bent perpendicularly relative to the first wall portion k1 and the second wall portion k2. However, the present invention is not limited to this embodiment. The aforementioned configuration enables the longitudinal wall 52 of the first supporting member 32 and the longitudinal wall 76 of the second supporting member 34 to support each other, thereby improving the overall structural strength and the supporting strength of the bracket device 24.

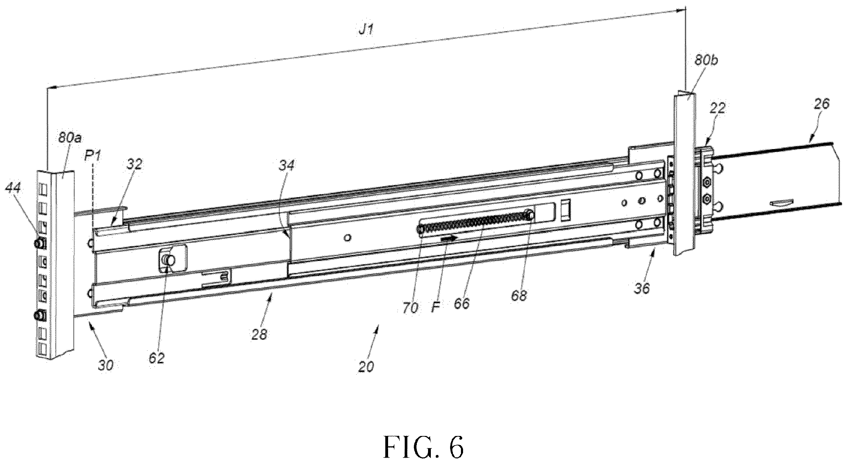

As shown in FIG. 2, FIG. 3 and FIG. 6, when it is desired to mount the slide rail mechanism 20 on a first rack including a first post 80a and a second post 80b which are spaced apart from each other by a first longitudinal depth J1, the engaging feature 62 can engage with the first predetermined feature 64a to retain the first supporting member 32 at the first predetermined position P1 relative to the reinforcing member 28, such that the first mounting member 44 on the first bracket 30 and the second mounting member 56 on the second bracket 36 are spaced apart from each other by the first distance X1. Accordingly, the slide rail mechanism 20 can be mounted on the first rack having the first longitudinal depth J1 by mounting the first mounting member 44 and the second mounting member 56 on the first post 80a and the second post 80b, respectively. Preferably, the second supporting member 34 drives the second mounting member 56 on the second bracket 36 to be mounted on the second post 80b of the first rack in response to a resilient force F provided by the resilient member 66, thereby enhancing reliability and safety in mounting the first mounting member 44 and the second mounting member 56 on the first post 80a and the second post 80b, respectively.

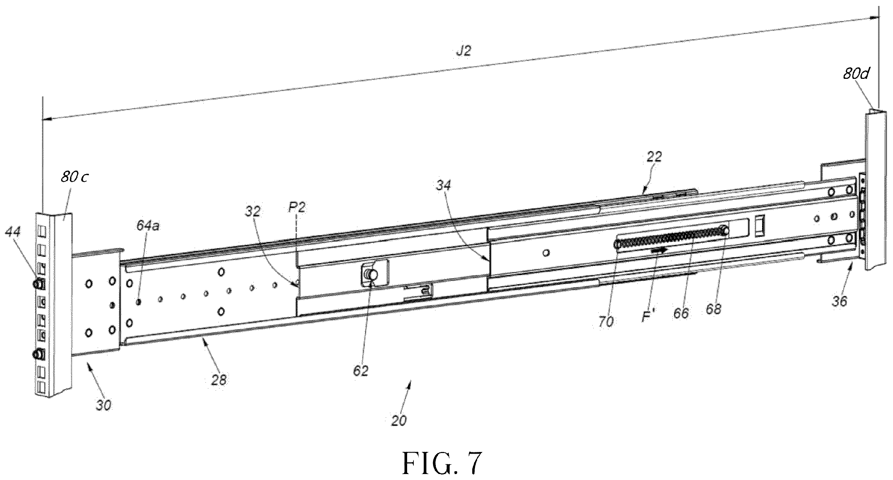

As shown in FIG. 2, FIG. 4 and FIG. 7, when it is desired to mount the slide rail mechanism 20 on a second rack including a first post 80c and a second post 80d spaced apart from each other by a second longitudinal depth J2 different from the first longitudinal depth J1, the engaging feature 62 can engage with the second predetermined feature 64b to retain the first supporting member 32 at the second predetermined position P2 relative to the reinforcing member 28, such that the first mounting member 44 on the first bracket 30 and the second mounting member 56 on the second bracket 36 are spaced apart from each other by the second distance X2. Accordingly, the slide rail mechanism 20 can be mounted on the second rack having the second longitudinal depth J2 by mounting the first mounting member 44 and the second mounting member 56 on the first post 80c and the second post 80d, respectively. Preferably, the second supporting member 34 drives the second mounting member 56 on the second bracket 36 to be mounted on the second post 80d of the second rack in response to a resilient force F' provided by the resilient member 66, thereby enhancing reliability and safety in mounting the first mounting member 44 and the second mounting member 56 on the first post 80c and the second post 80d, respectively.

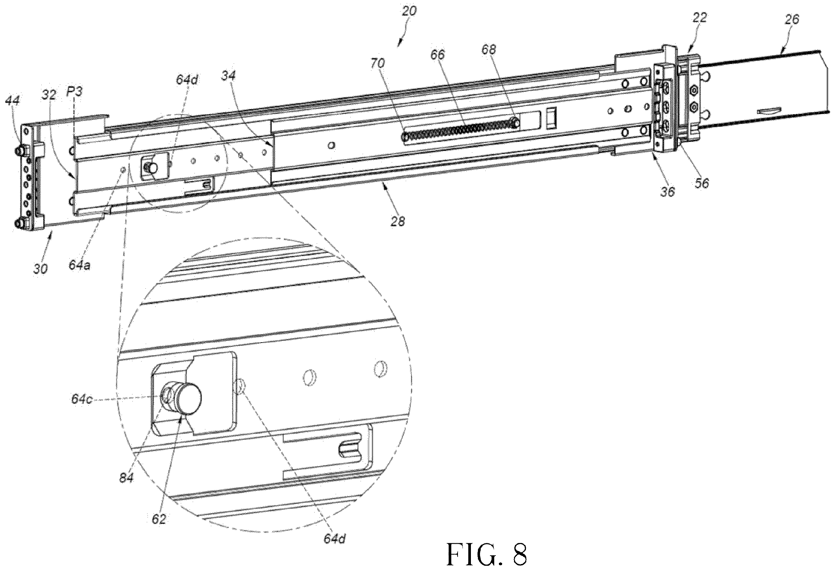

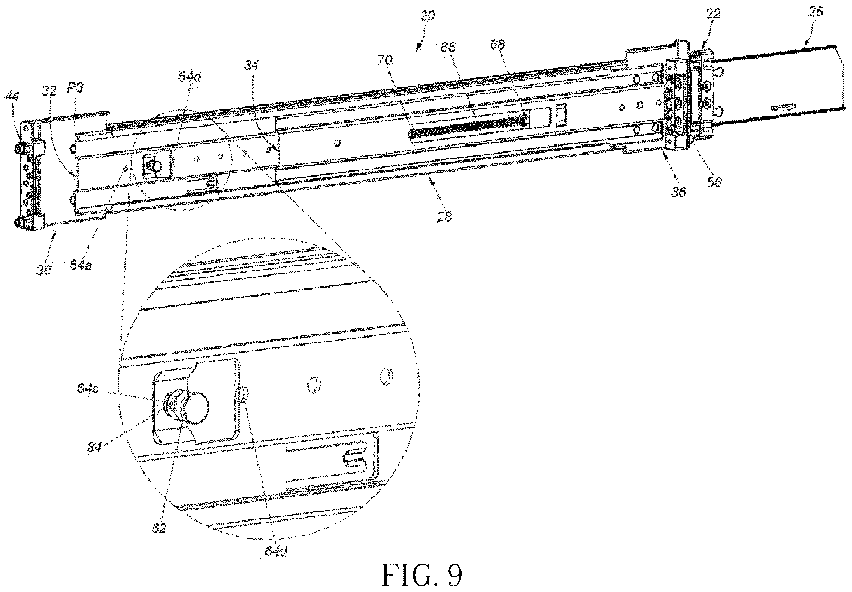

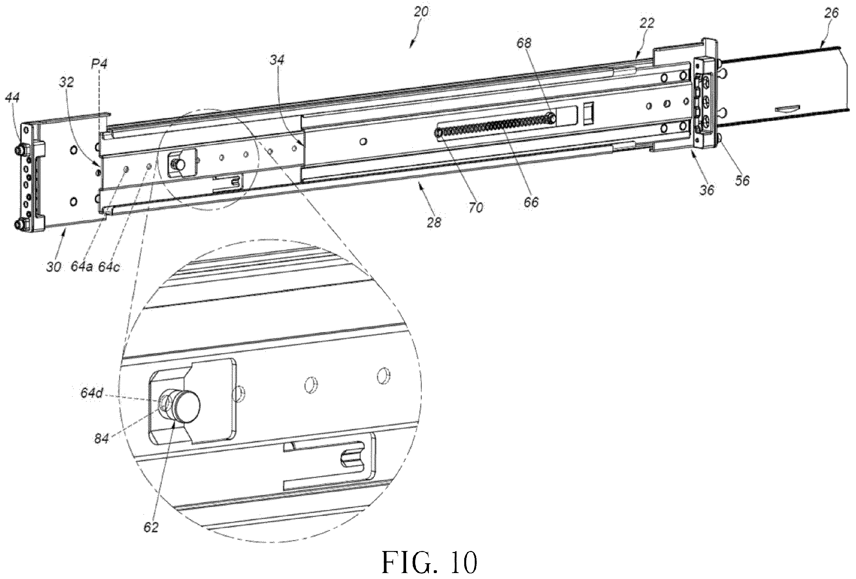

As shown in FIG. 8 to FIG. 10, the engaging feature 62 is movable between an engaging position (as shown in FIG. 8) and a disengaging position (as shown in FIG. 9). For example, as shown in FIG. 8, when the engaging feature 62 is located at the engaging position to engage with the third predetermined feature 64c, an extending portion 84 of the engaging feature 62 is inserted into the third predetermined feature 64c to retain the first supporting member 32 at a third predetermined position P3 relative to the reinforcing member 28, which is located between the first predetermined position P1 and the second predetermined position P2. As shown in FIG. 9, when the engaging feature 62 is located at the disengaging position to disengage from the third predetermined feature 64c, the extending portion 84 of the engaging feature 62 is withdrawn from the third predetermined feature 64c to allow the first supporting member 32 to move away from the third predetermined position P3 relative to the reinforcing member 28, thereby enabling an adjustment of a relative position of the first supporting member 32 and the reinforcing member 28, for example, to move the first supporting member 32 to a fourth predetermined position P4 as shown in FIG. 10. When the first supporting member 32 is moved to the fourth predetermined position P4 relative to the reinforcing member 28 and the engaging feature 62 is located at the engaging position, the extending portion 84 of the engaging feature 62 is inserted into the fourth predetermined feature 64d to retain the first supporting member 32 at the fourth predetermined position P4 relative to the reinforcing member 28.

From the above, the slide rail mechanism 20 and the bracket device 24 have the following characteristics.
1. The first supporting member 32 and the reinforcing member 28 are configured to be movable relative to each other, such that the distance between the first mounting member 44 and the second mounting member 56 can be adjusted by adjusting the relative position of the first supporting member 32 and the reinforcing member 28, thereby enabling the slide rail mechanism 20 to be mounted on different racks having different longitudinal depths.
2. The reinforcing member 28, the first supporting member 32, and the second supporting member 34 cooperatively form a three-segment component assembly and are movable relative to one another. The first supporting member 32 can be retained at different positions relative to the reinforcing member 28 through an engagement of the engaging feature 62 and a corresponding one of the plurality of predetermined features, thereby enabling the bracket device 24 to have an adjustable length within a predetermined length range, without any change of a relative position of the first supporting member 32 and the second supporting member 34, so as to prevent the adjustable length of the bracket device 24 from being affected by a resilient force and/or a maximum extension length provided by the resilient member 66.
3. The configuration, in which the reinforcing member 28 and the first supporting member 32 embrace the first supporting member 32 and the second supporting member 34, respectively, improves an overall structural strength and a supporting strength of the bracket device 24.
4. The second supporting member 34 can drive the second mounting member 56 on the second bracket 36 to be mounted on the second post 80b or 80d in response to the resilient force provided by the resilient member 66, thereby enhancing reliability and safety in mounting the first mounting member 44 and the second mounting member 56 on the first post 80a and the second post 80b of the first rack, respectively, or on the first post 80c and the second post 80d of the second rack, respectively.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A bracket device (24) arranged on a slide rail (22) and configured to be mounted on a rack, the bracket device (24) **characterized by**:
a reinforcing member (28) connected to the slide rail (22);
a first bracket (30) arranged on one of the slide rail (22) and the reinforcing member (28), and a first mounting member (44) being arranged on the first bracket (30);
a first supporting member (32) movably mounted on the reinforcing member (28);
a second supporting member (34) movably mounted on the first supporting member (32); and
a second bracket (36) arranged on the second supporting member (34), and a second mounting member (56) being arranged on the second bracket (36);
wherein a plurality of predetermined features (64a, 64b, 64c, 64d) are arranged on one of the reinforcing member (28) and the first supporting member (32), and an engaging feature (62) is arranged on another one of the reinforcing member (28) and the first supporting member (32);
wherein when the engaging feature (62) engages with one of the plurality of predetermined features (64a, 64b, 64c, 64d), the first supporting member (32) is located at a first predetermined position (P1) relative to the reinforcing member (28), and the first mounting member (44) on the first bracket (30) and the second mounting member (56) on the second bracket (36) are spaced apart from each other by a first distance (X1);
wherein when the engaging feature (62) engages with another one of the plurality of predetermined features (64a, 64b, 64c, 64d), the first supporting member (32) is located at a second predetermined position (P2) different from the first predetermined position (P1) relative to the reinforcing member (28), and the first mounting member (44) on the first bracket (30) and the second mounting member (56) on the second bracket (36) are spaced apart from each other by a second distance (X2) different from the first distance (X1).

2. The bracket device (24) of claim 1, **characterized in that** the reinforcing member (28) comprises a first wall (38a), a second wall (38b) and a longitudinal wall (40) connected between the first wall (38a) and the second wall (38b) of the reinforcing member (28), and the first wall (38a), the second wall (38b) and the longitudinal wall (40) of the reinforcing member (28) cooperatively define a reinforcing channel (42) whereon the first supporting member (32) is movably mounted.

3. The bracket device (24) of claim 2, **characterized in that** the first supporting member (32) comprises a first wall (50a), a second wall (50b) and a longitudinal wall (52) connected between the first wall (50a) and the second wall (50b) of the first supporting member (32), and the first wall (50a), the second wall (50b) and the longitudinal wall (52) of the first supporting member (32) cooperatively define a supporting channel (54) whereon the second supporting member (34) is movably mounted.

4. The bracket device (24) of claim 3, **characterized in that** the first wall (38a) and the second wall (38b) of the reinforcing member (28) are configured to embrace the first wall (50a) and the second wall (50b) of the first supporting member (32), respectively.

5. The bracket device (24) of claim 4, **characterized in that** the first wall (50a) and the second wall (50b) of the first supporting member (32) are configured to embrace a first wall (74a) and a second wall (74b) of the second supporting member (34), respectively.

6. The bracket device (24) of any of claims 1 to 5, **characterized in that** each of the plurality of predetermined features (64a, 64b, 64c, 64d) is a hole structure defined by at least one hole wall, and the engaging feature (62) is a pin.

7. The bracket device (24) of any of claims 1 to 6, **characterized in that** one of the reinforcing member (28) and the first supporting member (32) comprises a plurality of identification features (N1, N2), and another one of the reinforcing member (28) and the first supporting member (32) comprises a window (67) configured to reveal one of the plurality of identification features (N1, N2).

8. The bracket device (24) of any of claims 1 to 7, **characterized in that** a first restraining feature (61) is further arranged on the reinforcing member (28), a second restraining feature (63) is further arranged on the first supporting member (32), and when the first supporting member (32) is located at the second predetermined position (P2) relative to the reinforcing member (28), the first restraining feature (61) and the second restraining feature (63) engage with each other.

9. The bracket device (24) of claim 8, **characterized in that** one of the first restraining feature (61) and the second restraining feature (63) is a resilient arm.

10. The bracket device (24) of any of claims 1 to 9, further **characterized by** a resilient member (66), the first mounting member (44) and the second mounting member (56) being configured to be mounted on a first post (80a, 80c) and a second post (80b, 80d) of the rack, respectively, and the second supporting member (34) driving the second mounting member (56) on the second bracket (36) to be mounted on the second post (80b, 80d) of the rack in response to a resilient force (F, F') provided by the resilient member (66).

11. The bracket device (24) of claim 10, **characterized in that** the resilient member (66) is mounted between the first supporting member (32) and the second supporting member (34).

12. The bracket device (24) of any of claims 1 to 11, **characterized in that** the reinforcing member (28) has a first end (E1) and a second end (E2) opposite to the first end (E1), the first bracket (30) is located adjacent to the first end (E1) of the reinforcing member (28), the second bracket (36) is located away from the first end (E1) of the reinforcing member (28).

13. A slide rail mechanism (20) adapted for a rack, the slide rail mechanism (20) comprising a slide rail (22) and **characterized by**:
the bracket device (24) of any of claims 1 to 12, the bracket device (24) being arranged on the slide rail (22).

14. The slide rail mechanism (20) of claim 13, **characterized in that** the slide rail (22) has a first side (L1) and a second side (L2) opposite to the first side (L1), and the bracket device (24) is arranged on the first side (L1) of the slide rail (22).

15. The slide rail mechanism (20) of claim 14, further **characterized by** a movable rail (26) movably mounted on the second side (L2) of the slide rail (22).
